# EUROPEAN PATENT APPLICATION

(11) **EP 1 049 173 A1**
(43) Date of publication of application: **02.11.2000**
(21) Application number: 00302672.1
(22) Date of filing: 30.03.2000
(51) Int. Cl.: H01L 29/06, H01L 21/8234, H01L 29/423, H01L 21/28, H01L 21/32

(54) **Semiconductor devices with multiple power supplies and methods of manufacturing such devices**

(30) Priority: 28.04.1999 JP 12292899
(71) Applicant: FUJITSU LIMITED, Kawasaki-shi, Kanagawa 211-8588 (JP)
(72) Inventor: Yamaguchi, Shigeto, Kawasaki-shi, Kanagawa 211-8588 (JP); Gotoh, Kunihiko, Kawasaki-shi, Kanagawa 211-8588 (JP); Hirochi, Katsuji, Kawasaki-shi, Kanagawa 211-8588 (JP)
(74) Representative: Hitching, Peter Matthew

(57) **Abstract**

A method is provided to manufacture a semiconductor device which is capable of using multiple (three or more) power supplies by forming gate insulating films having different thicknesses. The method has the steps of: defining first, second and third active regions (AR1-3) on a surface of a semiconductor substrate (31); forming an insulating film (32) on the surfaces of the first, second and third active regions (AR1-3); removing the insulating film (32) on the surface of the second active region (AR2); forming an insulating film (34) on the surface of the second active region (AR2) and thickening the insulating films (32a) on the surfaces of the first and third active regions (AR1, AR3); removing the insulating film (32a) on the surface of the third active region (AR3); and forming an insulating film (36) on the surface of the third active region (AR3) and thickening the insulating films (32b, 34a) on the surfaces of the first and second active regions (AR1, AR2).

## Description

The present invention relates to a method of manufacturing a semiconductor device, and more particularly to a method of manufacturing a semiconductor device capable of using multiple power supplies by forming gate insulating films or capacitor dielectric films having different thicknesses.

The integration degree of semiconductor integrated circuit (IC) devices is becoming higher nowadays. Demands for semiconductor IC devices suitable for various applications are increasing. As the integration degree becomes higher, a lower voltage of a power supply is used. In order to be interoperable with previous circuits, there is a demand for semiconductor IC devices capable of using multiple power supply voltages. Power supply voltages of semiconductor devices are generally 5 V, 3.3 V, 2.5 V and the like. There is a tendency that a power supply voltage of 1.8 V will be used.

Previously-considered semiconductor products satisfy the specifications of a single power supply or two power supplies. A semiconductor device for two power supplies has two different thicknesses of gate insulating films of MOS transistors.

Gate insulating films having two different thicknesses are formed by the following method. First, gate insulating films having a predetermined thickness are formed for all transistors, and those gate insulating films formed in low voltage transistor regions are removed. Then, another gate insulating film is formed in all transistor regions.

If the gate insulating film is formed by thermal oxidation of silicon, thermal oxidation is performed twice. A thermal oxidation film formed by two thermal oxidation processes is thick, and a thermal oxidation film formed only by the second thermal oxidation is thin. Insulated gate electrode structures having different breakdown voltages can be formed by these thermal oxidation films having different thicknesses.

In addition to semiconductor devices capable of using two power supplies, there is also a demand for semiconductor devices capable of using three or more power supplies. However, manufacture technologies for semiconductor devices capable of using three or more power supplies are still not established.

It is therefore desirable to provide a method of manufacturing a multiple power supply semiconductor device capable of using three or more power supplies.

It is also desirable to provide a semiconductor device adapted for multiple power supplies.

According to an embodiment of one aspect of the present invention, there is provided a method of manufacturing a semiconductor device with multiple power supplies, comprising the steps of: defining first, second and third active regions on a surface of a semiconductor substrate; forming an insulating film on each of surfaces of the first, second and third active regions; removing the insulating film on the surface of the second active region; forming an insulating film on the surface of the second active region and changing thicker the insulating films on the surfaces of the first and third active regions; removing the insulating film on the surface of the third active region; and forming an insulating film on the surface of the third active region and changing thicker the insulating films on the surfaces of the first and second active regions.

According to an embodiment of another aspect of this invention, there is provided a semiconductor device with multiple power supplies, which comprises: (a) a first active region including a first insulated gate structure to which a first gate signal associated with a first power supply is applied, (b) a second active region including a second insulated gate structure to which a second gate signal associated with a second power supply is applied, and (c) a third active region including a third insulated gate structure to which a third gate signal associated with a third power supply is applied, wherein said first, second and third active regions are formed on a semiconductor substrate, said first, second, and third insulated gate structure have a first, second and third thermal oxide films, respectively, the first, second, and third thermal oxide films having decreasing thickness in this order, said second and third thermal oxide films are thermally grown on an equally experienced etched surface of the semiconductor substrate.

As described above, a semiconductor device embodying the invention is capable of using three or more power supplies.

Even if insulating films of different thicknesses or different kinds are formed, the influence of etching upon a semiconductor surface can be alleviated if the number of etching processes in each active region is limited. For example, damages to be caused by dry etching can be reduced. Reliability of manufactured semiconductor devices can therefore be improved.

Reference will now be made, by way of example, to the accompanying drawings, in which:
Figs. 1A to 1K are schematic cross sectional views of a substrate illustrating manufacture processes for a semiconductor device according to an embodiment of the invention.
Figs. 2A to 2G are schematic cross sectional views of a substrate illustrating manufacture processes for a semiconductor device according to another embodiment of the invention.
Figs. 3A to 3C are plan views and a schematic cross sectional view of a semiconductor device manufactured by an embodiment method.
Fig. 4 is a schematic cross sectional view showing the structure of a stacked-layer insulating film manufactured by another embodiment method.

Embodiments of the invention will be described with reference to the accompanying drawings.

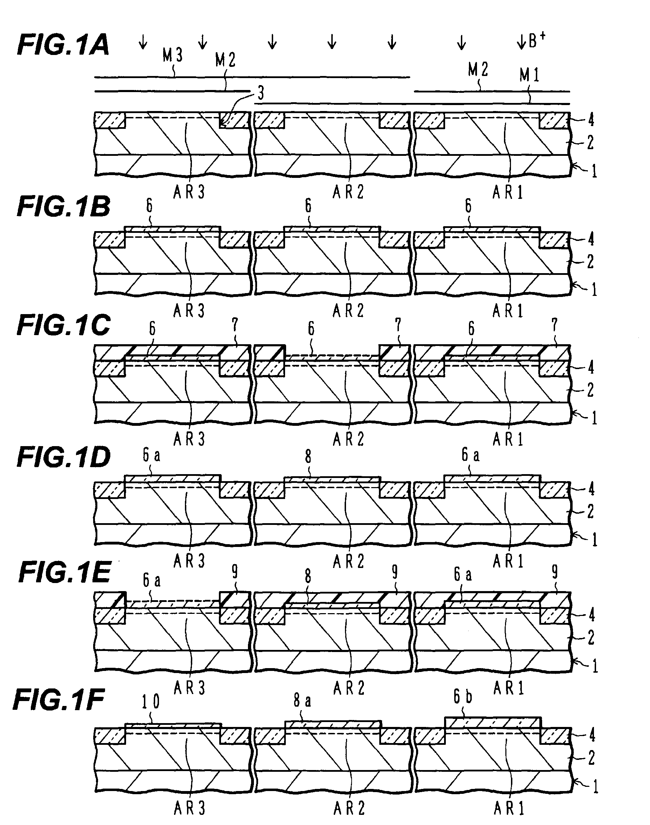

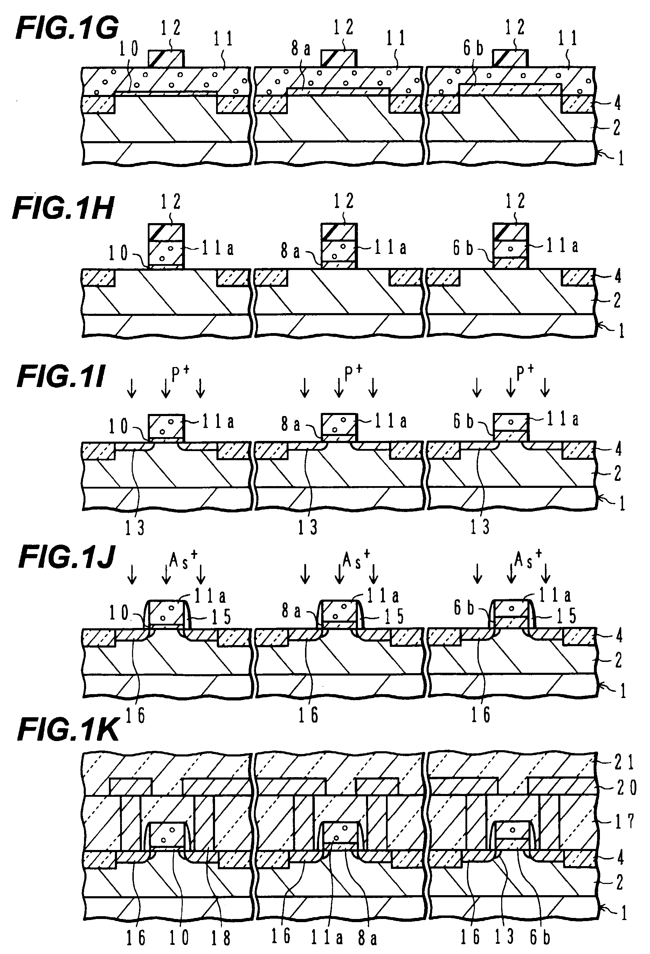

Figs. 1A to 1K are schematic cross sectional views of a substrate illustrating manufacture processes for a semiconductor device according to an embodiment of the invention. The manufacture processes will be described by taking n-channel MOS transistors as an example.

As shown in Fig. 1A, in the surface region of an n- or p-type substrate 1, p-type wells 2 are formed. In a surface region of the p-type well 2, a trench (groove) 3 is formed to a depth of about 300 nm by anisotropic dry etching. Thereafter, a silicon oxide film is formed filling the trench 3. For example, a silicon oxide film is deposited to a thickness of 400 nm by plasma enhanced (PE) chemical vapor deposition (CVD). For finer semiconductor devices, it is preferable to use high density (HD) PECVD excellent in embedding characteristics.

After the silicon oxide film is deposited, the surface thereof is polished through chemical mechanical polishing (CMP) to expose the surface of the p-type well 2. In this case, a silicon oxide film 4 is left in the trench and forms a trench isolation region. Regions surrounded by the trench isolation regions 4 are active regions AR1, AR2 and AR3. In Fig. 1A, although only three active regions AR1, AR2 and AR3 are shown, a plurality of these regions are actually formed.

By using a mask M of a resist layer or the like, boron ions B⁺ are implanted in desired regions to control the threshold voltage Vth of a MOS transistor to be formed. For example, as shown in Fig. 1A, by using a mask M1, Vth control ions are implanted into the active region AR3, next by using a mask M2, Vth control ions are implanted into the active region AR2, and then by using a mask M3, Vth control ions are implanted into the active region AR1.

These ion implantation processes are performed, for example, in the order of an acceleration energy of 15 keV and a dose on the order of 10¹² cm⁻². In order to form MOS transistors having different breakdown voltages, the doses for the three active regions AR1, AR2 and AR3 are changed to give different threshold voltages Vth. After each ion implantation, each of the masks M1, M2 and M3 is removed. If CMOS transistors are to be formed, other ion implantation processes are performed for p-channel transistor regions.

If capacitors as well as MOS transistors are to be formed, a mask having an opening corresponding to the lower electrode of a capacitor is formed, and impurities (e.g., n-type impurities for p-type wells) are doped into the substrate at a high concentration. If capacitors having different breakdown voltages are to be formed, a capacitor mask having openings corresponding to the respective capacitors is used.

For example, arsenic ions are implanted at an acceleration energy of 35 keV and a dose on the order of 10¹⁵ cm⁻². After the ion implantation, the mask is removed and annealing is performed, for example, for 20 minutes at 1000 °C, to activate implanted impurity ions.

After the regions doped with impurities at a high concentration are formed, structures similar to the MOS transistor gate insulating films and gate electrodes are formed. In this manner, high reliability capacitors having different breakdown voltages can be formed together with transistors.

As shown in Fig. 1B, the substrate surface is thermally oxidized in a wet atmosphere to form a gate oxide film 6. For example, a silicon oxide film is grown to a thickness of about 4 nm by wet thermal oxidation. The wet thermal oxidation is performed, for example, at 800 °C.

As shown in Fig. 1C, a resist pattern 7 of photoresist is formed on the substrate surface. The resist pattern 7 has an opening corresponding to the active region AR2. By using this resist pattern 7 as a mask, the exposed gate oxide film 6 is removed through wet etching using dilute hydrofluoric acid. In order to prevent the trench isolation region 4 from being etched, it is preferable to expose only the active region in the opening by aligning the mask with the side of the active region. The other masks to be described below are also aligned in this manner.

Thereafter, the resist pattern 7 is removed.

As shown in Fig. 1D, a new silicon oxide film 8 is formed by thermal oxidation on the surface of the active region AR2 having an exposed silicon surface. In this case, the already formed silicon oxide films 6 continue to grow, forming silicon oxide films 6a having an increased thickness. For example, the conditions of forming the new silicon oxide film 8 are similar to the wet oxidation conditions described with reference to Fig. 1B.

As shown in Fig. 1E, a resist pattern 9 is formed on the substrate surface. The resist pattern 9 has an opening corresponding to the surface of the active region AR3. By using this resist pattern 9 as a mask, the silicon oxide film 6a on the active region AR3 is removed by wet etching using dilute hydrofluoric acid. Thereafter, the resist pattern 9 is removed.

As shown in Fig. 1F, a new silicon oxide film 10 is formed by thermal oxidation on the surface of the active region AR3 having an exposed silicon surface. In this case, the already formed silicon oxide films 8 and 6a continue to grow, forming silicon oxide films 8a and 6b having increased thicknesses. For example, the thermal oxidation conditions are similar to the wet oxidation conditions described with reference to Fig. 1B.

The thickness of an oxide film formed by thermal oxidation of silicon does not linearly increases relative to the oxidation time, but an increment of the grown film thickness reduces with time. For example, in the thermal oxidation process shown in Fig. 1D, if a new thermal oxidation film is formed to a thickness of 4 nm on the silicon surface, the already formed thermal oxidation film 6 having a thickness of 4 nm is further oxidized to have a thickness of thinner than 6 nm.

In the thermal oxidation process shown in Fig. 1F, if the silicon oxide film 10 is grown to a thickness of about 4 nm on the silicon surface, the silicon oxide film 8 having the thickness of 4 nm becomes a silicon oxide film having a thickness of smaller than about 6 nm, and the silicon oxide film 6a having the thickness of about 6 nm becomes a silicon oxide film having a thickness of 7 to 8 nm.

The thermal oxidation conditions are determined in the following manner. First, a desired thickness of a silicon oxide film to be formed at the last stage is determined, and the oxidation conditions for obtaining the desired thickness of this silicon oxide film are determined. Then, the oxidation conditions at the remaining two stages suitable for obtaining silicon oxide films having different thicknesses are determined.

The processes described above are only an example of forming insulating films having three different thicknesses, and various other processes may be used. For example, the kind of an insulating film or an insulating film forming method may be changed. A method of removing an insulating film may also be changed.

In the active regions AR2 and AR3, the thermal oxidation films previously formed are removed, and thermal oxidation films are newly formed in these regions. In the process shown in Fig. 1C, the thermal oxidation film 6 on the surface of the active region AR3 may be removed. This process is a process of removing the thermal oxidation film 6 in the active region AR2. Therefore, in order to remove also the thermal oxidation film 6 in the active region AR3, it is sufficient to change only the pattern of the mask, and the time taken by this process will not be prolonged. If the thermal oxidation film 6 in the active region AR3 is removed by this process, the thickness of the thermal oxidation film to be removed in the process shown in Fig. 1E reduces and the load on this process can be lessened.

However, since the thermal oxidation films on the surface of the active region AR3 are removed by two etching processes, these processes may deteriorate the silicon surface. If the silicon oxide film is removed by dry etching, it is inevitable that the silicon surface is damaged by plasma. As dry etching processes are repeated, the damages increase. With the processes shown in Fig. 1A to 1F, the etching process for the insulating film is performed once for both the active regions AR2 and AR3.

As shown in Fig. 1G, on the surface of the substrate formed with the gate oxide films 10, 8a and 6b, a polysilicon film 11 is deposited, for example, to a thickness of 100 nm by CVD using source gas of SiH₄ at a temperature of 650°. Thereafter, a resist layer is formed on the polysilicon layer 11, and exposed and developed to form resist patterns 12. The resist pattern 12 has a shape corresponding to the shape of a gate electrode of a MOS transistor to be formed. If a capacitor is also formed, the upper electrode of the capacitor is formed by this process.

As shown in Fig. 1H, by using the resist patterns 12 as a mask, the polysilicon layer 11 is etched to leave gate electrodes 11a made of polysilicon. The polysilicon layer 11 is etched under the conditions that the gate oxide film is partially left unetched.

For example, the polysilicon layer 11 is etched under the following conditions.
Etchant: Cl₂/O₂ mixture gas
Chamber Pressure: several mTorr

Instead of the polysilicon gate electrode, other gate electrodes may also be used, such as a gate electrode of a polycide (poly-silicon + silicide) lamination structure and a polysilicon or polycide gate electrode whose surface is covered with an oxide film or a nitride film.

As shown in Fig. 11, phosphorous ions P⁺ are implanted into the substrate surface layer. With this ion implantation, n-type impurities are doped into the gate electrode 11a of polysilicon, and regions 13 doped with n-type impurities are formed in both side areas of the gate electrode in each of the active regions AR1, AR2 and AR3.

As shown in Fig. 1J, a silicon oxide film is deposited by CVD on the substrate surface to a thickness of for example, 100 nm. The silicon oxide film on the flat surface is etched and removed by anisotropic dry etching. As a result, side spacer oxide films are left only on the side walls of the gate electrode 11a.

Arsenic ions As⁺ are implanted downward into the semiconductor substrate formed with the side spacer oxide films. For example, ion implantation is performed at an acceleration energy of 30 keV and a dose on the order of 10¹⁵ cm⁻². Regions 16 having a high impurity concentration of an n-type are therefore formed in both side areas of the gate electrode outside of the side spacer oxide films 15. The arsenic ions are also doped in the gate electrode 11a. If CMOS transistors are formed, another ion implantation is performed for p-channel transistors. Thereafter, the semiconductor substrate is subjected to rapid thermal annealing (RTA) for 10 seconds at a temperature of about 1000 °C to activate implanted impurity ions.

As shown in Fig. 1K, an interlayer insulating film 17 is formed on the substrate surface. The material pf the interlayer insulating film 17 may be silicon oxide, phosphosilicate glass (PSG), borophosphosilicate glass (BPSG) or the like. If necessary, the surface of the interlayer insulating film 17 is planarized. Reflow, chemical mechanical polishing (CMP) or the like is used for this planarizing process. A resist pattern is formed on the interlayer insulating film 17. Contact holes are etched through the interlayer insulating film 17, reaching the source/drain regions 16 and gate electrode 11a. The resist pattern is thereafter removed. A film, e.g., a W film, is blanket-grown to fill the contact hole with a W plug. The W layer on the flat surface is removed through etch-back or CMP. Thereafter, upper wiring lines 20 connected to the plugs 18 are formed by depositing a conductive layer and pattering it. The wiring line 20 is made of a single metal layer or a plurality of metal layers containing Al or Al alloy as its or their main components. Another interlayer insulating film 21 is formed covering the wiring lines 20. If necessary, processes of forming contact holes, upper wiring lines, and an interlayer insulating film are repeated. A passivation film such as a silicon nitride film is formed as the uppermost layer.

Instead of forming transistors and capacitors directly on the semiconductor substrate, they may be formed on a polysilicon layer formed on an insulating film on a semiconductor substrate. In this case, an insulating film (oxide film) is formed on the surface of a first polysilicon layer, and on this insulating film a second polysilicon layer is formed.

In the above-described embodiment, Vth control ion implantation is performed by the process shown in Fig. 1A. Vth control ion implantation may be performed by using the resist patterns 7 and 9 used by the etching processes shown in Figs. 10 and 1E.

For example, in the process shown in Fig. 1C, Vth control ion implantation for the active region AR2 is performed, and in the process shown in Fig. 1E, Vth control ion implantation for the active region AR3 is performed. In this manner, the number of masks can be reduced. These ion implantation processes are preferably performed before the gate oxide films 6 and 6a are removed.

For example, in the process shown in Fig. 1A boron ions B⁺ are implanted into all active regions at an acceleration energy of 15 keV and a dose on the order of 10¹² cm⁻², in the process shown in Fig. 1C boron ions B⁺ are implanted into the active region AR2 at an acceleration energy of 15 keV and a dose on the order of 10¹¹ cm⁻², and in the process shown in Fig. 1E boron ions B⁺ are implanted into the active region AR3 at an acceleration energy of 15 keV and a dose on the order of 10¹¹ cm⁻². Different Vth control ion implantation processes are performed for three different kinds of active regions in the above manner, and gate insulating films having different film thicknesses are formed.

In the embodiment described above, although gate insulating films having three different film thicknesses are formed, gate insulating films having four different film thicknesses may be formed.

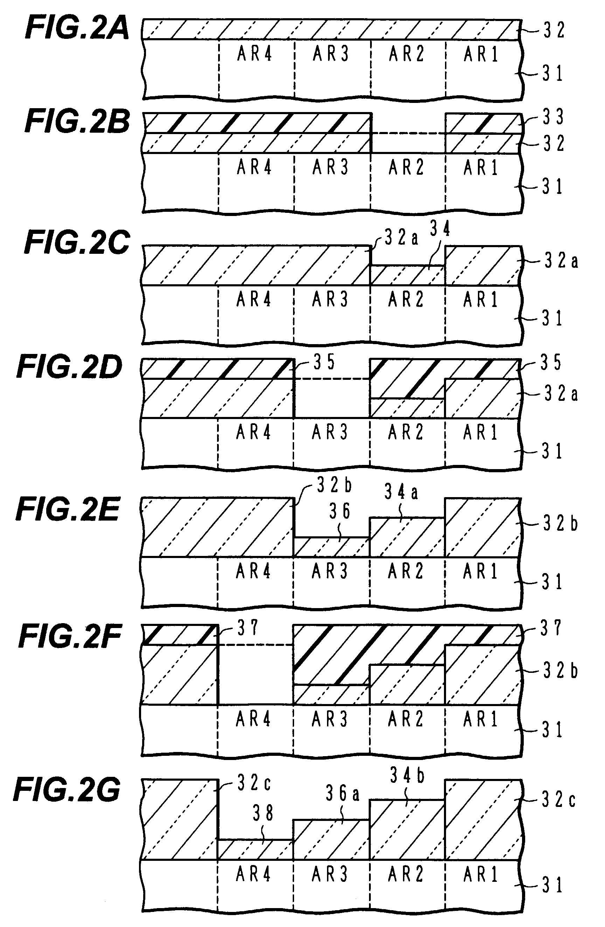

Figs. 2A to 2G are schematic cross sectional views illustrating the processes of forming gate insulating films having four different film thicknesses.

As shown in Fig. 2A, a thermal oxidation film 32 is formed on the surface of a silicon substrate 31.

As shown in Fig. 2B, a resist pattern 33 is formed on the surface of the thermal oxidation film 32, having an opening corresponding to an active region AR2. By using the resist pattern 33 as a mask, the silicon oxide film 32 exposed in the opening is wet-etched and removed by using dilute hydrofluoric acid. Thereafter, the resist pattern 33 is removed.

As shown in Fig. 20, the substrate surface is thermally oxidized. A new thermal oxidation film 34 is formed on the exposed silicon surface in the active region AR2. The already formed silicon oxide film 32 becomes a silicon oxide film 32a having an increased thickness by this thermal oxidation.

As shown in Fig. 2D, a resist pattern 35 is formed on the substrate surface. The resist pattern 35 has an opening corresponding to an active region AR3. By using the resist pattern 35 as a mask, the silicon oxide film 32a exposed in the opening is wet-etched and removed by using dilute hydrofluoric acid. Thereafter, the resist pattern 35 is removed.

As shown in Fig. 2E, a new thermal oxidation film 36 is formed on the exposed silicon surface in the active region AR3. The already formed silicon oxide films 34 and 32a become silicon oxide films 34a and 32b having increased thicknesses by this thermal oxidation.

As shown in Fig. 2F, a resist pattern 37 is formed on the substrate surface. The resist pattern 37 has an opening corresponding to an active region AR4. By using the resist pattern 37 as a mask, the silicon oxide film 32b exposed in the opening is wet-etched and removed by using dilute hydrofluoric acid. Thereafter, the resist pattern 37 is removed.

As shown in Fig. 2G, a new thermal oxidation film 38 is formed by thermal oxidation on the exposed silicon surface in the active region AR4. The already formed silicon oxide films 36, 34a and 32b become silicon oxide films 36a, 34b and 32c having increased thicknesses by this thermal oxidation. As above, by repeating similar processes, gate insulating films having desired different film thicknesses can be formed.

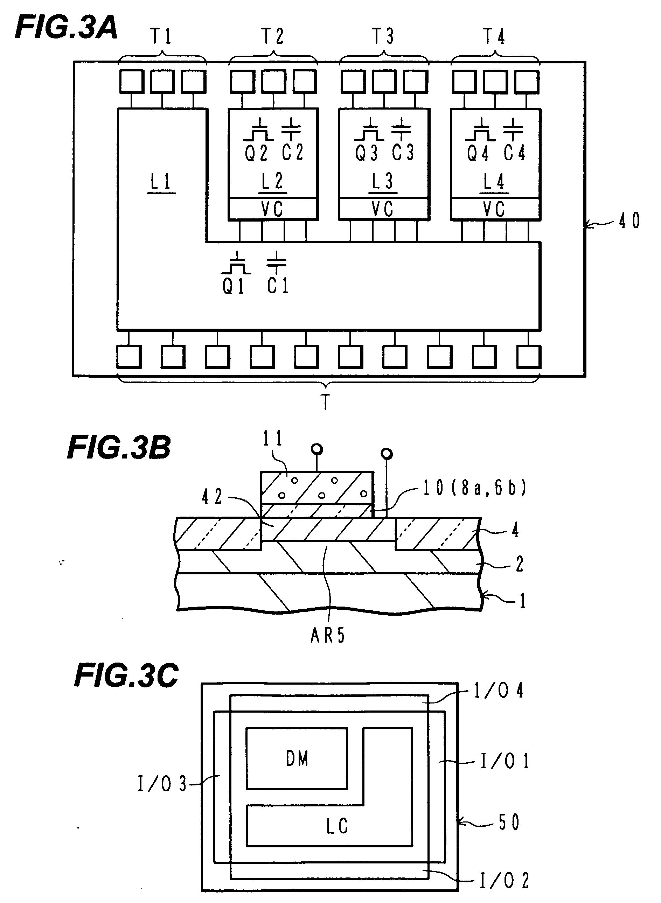

Fig. 3A is a plan view schematically showing an example of the structure of a semiconductor integrated circuit device with MOS transistors having different gate oxide film thicknesses. Formed in a central area of a silicon chip 40 are a circuit area L1 using a power supply voltage of 1.8 V, a circuit area L2 using a power supply voltage of 2.5 V, a circuit area L3 using a power supply voltage of 3.3 V, and a circuit area L4 using a power supply voltage of 5 V. The circuit areas have MOS transistors Q1, Q2, Q3 and Q4 and capacitors C1, C2, C3 and C4. The MOS transistors are formed by the processes shown in Figs. 1A to 1K and Figs. 2A to 2G and have different gate oxide film thicknesses.

Each of the capacitors C1 to C4 has the structure shown in Fig. 3B. In an active region AR5 in the surface layer of a p-type well 2, an n-type region 42 is formed. This n-type region 42 is formed by ion implantation, for example, in the process shown in Fig. 1A. A silicon oxide film 10 (8a, 6b) is formed on the surface of the n-type region 42. This silicon oxide film can be formed by the process same as the gate oxide film forming process in the manufacture processes shown in Figs. 1A to 1K and Figs. 2A to 2G.

Capacitors having different dielectric film thicknesses can therefore be formed in correspondence with different power supply voltages. On the dielectric film 10, an upper electrode 11 made of polysilicon or polycide is formed by the process same as the gate electrode forming process.

In Fig. 3A, voltage converter circuits VC are formed in connection areas between the circuit areas L2, L3 and L4 and the circuit area L1. Terminals T1, T2, T3 and T4 are used as power supply terminals for different power supply voltages and as signal input terminals. Terminals T are used as output terminals for the circuit area L1.

Fig. 3C shows another example of the structure of a semiconductor integrated circuit device. In a central area of a semiconductor (Si) chip 50, a dynamic random access memory (DRAM) circuit DM using a power supply voltage of 2.5 and a logic circuit LC using a power supply voltage of 1.8 V are formed. In the peripheral area of the chip 50, input/output circuits I/O using a power supply voltage of 3.3 V or 5 V are formed. MOS transistors in the circuits using different power supply voltages have different gate oxide film thicknesses. The higher the power supply voltage, the thicker the gate oxide film of each MOS transistor.

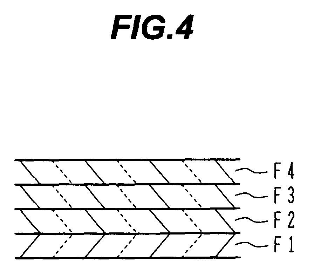

In the above-described embodiments, silicon oxide films having different thicknesses are formed. The kind of an insulating film is not limited only to the silicon oxide film. Metal-insulator semiconductor (MIS) transistors may be formed, in place of MOS transistors. Fig. 4 shows an insulating film structure having different kinds of insulating films stacked one upon another. Insulating films F1, F2, F3, and F4 are laminated to form a stacked-layer insulation film. The insulating film F1 is an oxide film, and the insulating films F2, F3 and F4 are nitride films. A combination of other films may also be used. Each insulating film may be formed by various methods such as thermal oxidation, thermal nitridation, CVD, and sputtering.

The present invention has been described in connection with the preferred embodiments. The invention is not limited only to the above embodiments. It will be apparent to those skilled in the art that various modifications, improvements, combinations, and the like can be made.

This application is based on Japanese Patent Application HEI 11-122928, filed on April 28, 1999, the entire contents of which are incorporated herein by reference.

## Claims

1. A method of manufacturing a semiconductor device with multiple power supplies, comprising the steps of:
(a) defining first, second and third active regions on a surface of a semiconductor substrate;
(b) forming an insulating film on surfaces of the first, second and third active regions;
(c) removing the insulating film on the surface of the second active region;
(d) forming an insulating film on the surface of the second active region and changing thicker the insulating films on the surfaces of the first and third active regions;
(e) removing the insulating film on the surface of the third active region; and
(d) forming an insulating film on the surface of the third active region and changing thicker the insulating films on the surfaces of the first and second active regions.

2. A method of manufacturing a semiconductor device with multiple power supplies according to claim 1, further comprising a step of forming electrodes on the insulating films on the first, second and third active regions.

3. A method of manufacturing a semiconductor device with multiple power supplies according to claim 2, wherein the electrodes are gate electrodes overlaying the first, second and third active regions respectively, and the method further comprises a step of forming source/drain regions on both sides of each of the gate electrodes.

4. A method of manufacturing a semiconductor device with multiple power supplies according to claim 1, 2 or 3, wherein:
said step (c) includes a sub-step of forming a mask over the surface of the semiconductor substrate, the mask having an opening corresponding to the second active region, and a sub-step of removing the insulating film on the surface of the second active region by using the mask; and
said step (e) includes a sub-step of forming a mask over the surface of the semiconductor substrate, the mask having an opening corresponding to the third active region, a sub-step of removing the insulating film on the surface of the third active region by using the mask.

5. A method of manufacturing a semiconductor device with multiple power supplies according to claim 4, wherein said step (c) further includes a sub-step of doping impurities into the second active region by using the mask.

6. A method of manufacturing a semiconductor device with multiple power supplies according to claim 4 or 5, wherein said step (e) further includes a sub-step of doping impurities into the third active region by using the mask.

7. A method of manufacturing a semiconductor device with multiple power supplies according to any preceding claim, wherein said steps (c) and(e) use masks whose openings are aligned with sides of the active regions.

8. A method of manufacturing a semiconductor device with multiple power supplies according to any preceding claim, further comprising the step of doping the first, second, and third active regions after step (a).

9. A method of manufacturing a semiconductor device with multiple power supplies according to claim 8, wherein doping levels in the first, second and third active regions are substantially the same, and the semiconductor device includes capacitors.

10. A method of manufacturing a semiconductor device with multiple power supplies according to claim 8, wherein doping levels in the first, second and third active regions are different, and the semiconductor device includes MIS transistors of different threshold voltage.

11. A semiconductor device with multiple power supplies, which comprises:
(a) a first active region including a first insulated gate structure to which a first gate signal associated with a first power supply is applied,
(b) a second active region including a second insulated gate structure to which a second gate signal associated with a second power supply is applied, and
(c) a third active region including a third insulated gate structure to which a third gate signal associated with a third power supply is applied,
wherein said first, second and third active regions are formed on a semiconductor substrate,
said first, second, and third insulated gate structure have a first, second and third thermal oxide films, respectively, the first, second, and third thermal oxide films having decreasing thickness in this order,
said second and third thermal oxide films are thermally grown on an equally experienced etched surface of the semiconductor substrate.

12. A semiconductor device, manufactured by a method as claimed in any one of claims 1 to 10.
